Europäisches Patentamt

European Patent Office

Office européen des brevets

(11) Publication number: **0 580 207 A1**

# EUROPEAN PATENT APPLICATION

(21) Application number: **93201945.8**

(22) Date of filing: **02.07.93**

(51) Int. Cl.5: **G01D 5/16**

(30) Priority: **16.07.92 US 914629**

(43) Date of publication of application:
**26.01.94 Bulletin 94/04**

(84) Designated Contracting States:
**DE FR GB**

(71) Applicant: **GENERAL MOTORS CORPORATION**
**General Motors Building**
**3044 West Grand Boulevard**
**Detroit Michigan 48202(US)**

(72) Inventor: **Kiess, Ronald J.**
**RR8, Box 322**
**Decatur, IN 46733(US)**

(74) Representative: **Jehan, Robert et al**
**Patent Section,**
**1st Floor,**
**Gideon House,**
**28 Chapel Street**
**Luton, Bedfordshire LU1 2SE (GB)**

(54) **Method and device for sensing movement of a ferro-magnetic object.**

(57) A device (10) for sensing the movement of a ferromagnetic object (12) having magnetic discontinuities (18, 20) along its surface, includes two magnetically biased magneto-resistive elements (MR1, MR2) operated in a differential mode and circuitry (46-52) for producing a digital output signal (Vout) indicative of the movement of the discontinuities (18, 20) on the surface of the ferromagnetic object (12) relative to the magneto-resistive elements (MR1, MR2).

FIG. 1

EP 0 580 207 A1

This invention relates to a method of and device for sensing movement of a ferromagnetic object, for example to a sensor device having dual magneto-resistive elements operated in a differential mode to provide a differential voltage signal and circuitry for processing the differential voltage signal to generate a digital output signal indicative of the sensed movement of a ferromagnetic object.

In the past, conventional variable reluctance sensors have been used to sense the movement, speed and/or position of ferromagnetic bodies such as racks, gears or wheels having toothed/slotted surfaces. Typically, these variable reluctance sensors include a permanent magnet disposed on a pole piece, with a pick-up coil for sensing the time rate of change in magnetic flux passing through the pole piece as surface discontinuities of the ferromagnetic body move past the pole piece. Since the magnitude of the voltage induced in the pick-up coil is proportional to the time rate of change in magnetic flux, it has been found that variable reluctance sensors are not practical for measuring slowly moving ferromagnetic objects. The variable reluctance sensor also has another limitation in that it is known to be quite susceptible to the pick-up of electrical noise.

Presently, the possibility of replacing conventional variable reluctance type sensors with sensors employing magneto-resistive elements is being explored. The resistance of a magneto-resistor depends upon the intensity of the magnetic field passing through it rather than the time rate of change in magnetic flux, as with a variable reluctance sensor. As a consequence, when magneto-resistor sensors are properly biased with a magnetic field, they are capable of detecting the movement of ferromagnetic objects down to near zero velocities. It has also been found that sensors employing magneto-resistors are much less susceptible to the pick-up of electrical noise than conventional variable reluctance sensors.

One of the major concerns associated with the use of magneto-resistors for motion sensors is that of temperature stability, since the resistance values of magneto-resistor elements vary significantly with changes in temperature. This is particularly true in applications which require the motion sensor to produce a pulsed or digital output signal which accurately represents movement of a ferromagnetic object. Typically, the voltage drop across a magneto-resistor element is processed by electrical thresholding circuitry to generate the sensor output signal. Consequently, any temperature drift in resistance of the magneto-resistor element, or the magnitude of the biasing current passing it, causes the magnitude of the DC component of the magneto-resistor voltage drop also to drift. This generally results in false thresholding, which in turn produces inaccuracies in the sensor output signal.

The present invention seeks to provide an improved method of and device for sensing movement of a ferromagnetic object.

According to one aspect of the present invention, there is provided a device for sensing movement of a ferromagnetic object as specified in claim 1.

According to another aspect of the present invention, there is provided a method of sensing movement of a ferromagnetic object as specified in claim 7.

In some embodiments, the invention can provide a motion sensor having two magnetically biased magneto-resistor elements in a configuration that inherently compensates for the temperature drift in the resistances of the two magneto-resistor devices with temperature so that simple threshold circuitry can be used to generate a digital output signal which accurately indicates the movement of magnetic discontinuities in the surface a ferromagnetic object in relation to the magneto-resistor elements.

This is accomplished in the preferred embodiment by positioning two magneto-resistive elements at substantially the same distance from the surface of the ferromagnetic object and spaced apart from each other by a distance less than the smallest width separating successive magnetic discontinuities on the ferromagnetic object. The magneto-resistive elements are biased with a magnetic field such that movement of the discontinuities relative to the magneto-resistive elements modulates their respective resistances. Electrical excitation is employed to produce a voltage drop across each magneto-resistive element in accordance with its respective resistance value. Electronic circuitry is then employed to produce a digital output signal indicative of the movement of the ferromagnetic object in response to the difference or differential voltage between the voltage drops appearing across the magneto-resistive elements.

Due to the spacing separating the magneto-resistive elements in this embodiment, the variation in resistance and voltage drop across one of these elements will lead in time to a corresponding variation in resistance and voltage drop across the other element induced by movement of the ferromagnetic object. Due to this lead-lag relationship, the differential voltage between the two magneto-resistive voltage drops then consists of a series of interlaced positive and negative going pulses corresponding to the movement of ferromagnetic discontinuities past the magneto-resistive elements.

Preferably, the discontinuities on the ferromagnetic object consist of interlaced teeth and slots and the differential voltage signal is amplified and coupled to the inputs of a hysteresis comparator.

The comparator generates a digital output signal which changes between high and low states as the differential voltage exceeds or drops below predetermined upper and lower threshold voltages. As a consequence, the digital output signal may be indicative of the movement of slot and tooth edges on the ferromagnetic object past the magneto-resistive elements.

A principle advantage of the preferred embodiment is its insensitivity to changes in operating temperature. This is because the sensor responds to the difference or differential voltage appearing across the magneto-resistive elements. Since the resistances of the magneto-resistive elements change by essentially the same amount as temperature varies, these changes tend to cancel each other out in the differential voltage signal. As a consequence, the preferred embodiment provides inherent temperature compensation for variations in the resistance of the magneto-resistive elements.

An embodiment of the present invention is described below, by way of illustration only, with reference to the accompanying drawings, in which:

Figure 1 is a plan view of an embodiment of device for sensing the motion of a ferromagnetic object;

Figure 2 is an end view of the sensing device of Figure 1 taken along line 2-2 of Figure 1;

Figure 3 is a circuit diagram of an embodiment for electronic circuitry contained within the device of Figure 1;

Figures 4a to 4e are a series of graphs representing the time variation in voltages appearing across selected junctions of the circuit of Figure 3;

Figure 5 is a circuit diagram of another embodiment of electronic circuitry for the device of Figure 1;

Figures 6a to 6d are a series of graphs representing the time variation in voltages appearing across selected junctions of the circuits of Figures 5 and 7; and

Figure 7 is a circuit diagram of another embodiment of electronic circuitry for the device of Figure 1.

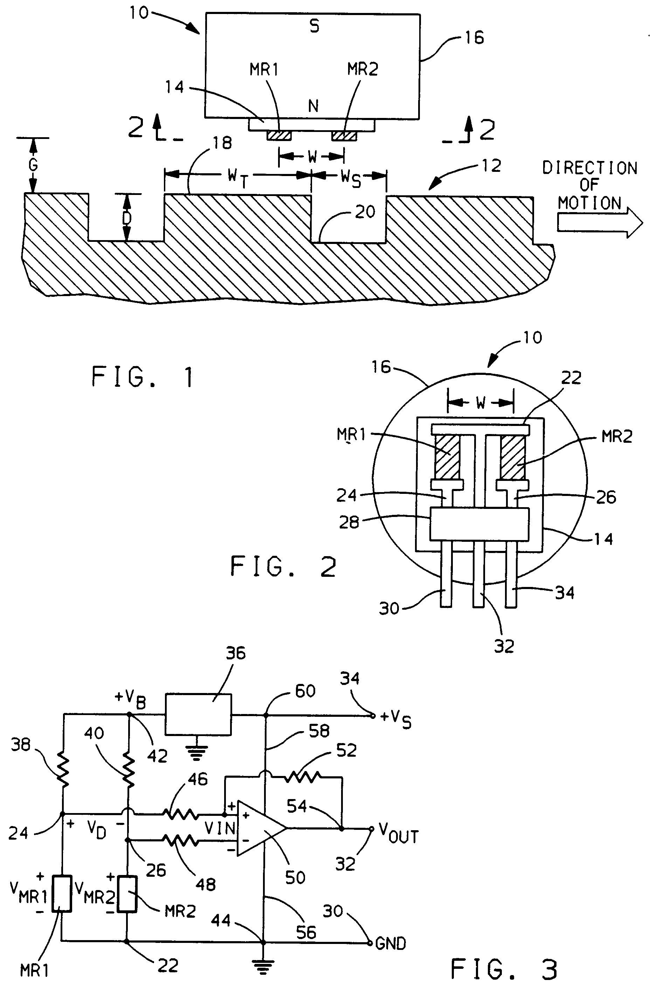

Referring to Figure 1, there is shown a device 10 for sensing the relative movement of a ferromagnetic object 12 formed of a magnetic material, such as iron. As shown, ferromagnetic device 10 moves in the indicated direction relative to sensing device 10. It will be recognized that the relative motion could also result by holding the ferromagnetic object 12 stationary, while moving the sensing device 10.

Sensing device 10 includes two magneto-resistive elements MR1 and MR2 disposed on an insulating substrate 14 and spaced apart by a distance W. Preferably, the magneto-resistive elements MR1, MR2 are fabricated using known techniques from indium antimonium (InSb) on a galium arsenide (GAAs) substrate 14; however, any other suitable materials or processes could be used in fabricating the magneto-resistors (see for example, US-A- 5,038,130, US-A- 4,939,456, US-A- 4,978,938, and US-A-4, 926,154). The magneto-resistive elements MR1 and MR2 are both spaced substantially the same distance G from the surface of the ferromagnetic object 12, the distance G commonly being referred to as the sensor air gap.

The sensing device 10 further includes a permanent magnet 16 for generating a magnetic field passing through and biasing magneto-resistors MR1 and MR2. The magnetic field could alternatively be established by an electromagnet formed from a current driven coil, if desirable. With magnet 16 oriented as shown in Figure 1, the magnetic field passes vertically through the magneto-resistor elements, into the the air gap, and then into the ferromagnetic object 12.

The ferromagnetic object 12 can be in the form of a moving rack, a rotating gear, wheel, or disc having successive magnetic surface discontinuities which move relative to the sensing device 10. In the embodiment illustrated in Figure 1, the magnetic surface discontinuities take the form of successive teeth 18 and slots 20 cut to a depth D into the surface of ferromagnetic object 12. Each tooth and each slot is shown as having a width designated by $W_T$ and $W_S$ respectively; although these widths could differ from one tooth/slot to another tooth/slot. The sensing device 10 can provide information regarding the absolute position of a ferromagnetic object when its slots and teeth have non-uniform widths.

In operation, the movement of the teeth 18 and slots 20 of the ferromagnetic object 12 past the sensing device 10 modulates the intensity of the magnetic field passing through each magneto-resistive element MR1 and MR2. The intensity of the magnetic field passing through a magneto-resistor element is maximized as a tooth passes under the magneto-resistor element and minimized as a slot passes under the magneto-resistor element. As a consequence, the resistance of the magneto-resistor element is increased by the former and decreased by the latter, thereby providing an indication of the movement of the ferromagnetic object 12. As a result of the spacing W between the magneto-resistive elements, changes in the resistance of element MR1 will lead in time the corresponding changes which would occur in the resistance of element MR2 as ferromagnetic object 12 moves in the direction indicated in Figure 1.

Referring to Figure 2, the view of the sensing device 10 shown provides detail to the layout of the magneto-resistive elements MR1 and MR2 on insulating substrate 14. Magneto-resistors MR1 and MR2 are electrically connected to each other at respective ends by electrical conductor 22, with the opposite ends being electrically connected to conductors 24 and 26 respectively. As shown, the magneto-resistor elements are fabricated in the form of elongated rectangles, but they may just as easily be formed in long serpentine patterns to produce increased sensitivity to changes in the intensity of the biasing magnetic field. In this case, the width W would represent an effective or average width separating the serpentine magneto-resistor elements.

Conductors 22, 24 and 26 provide input lines to an integrated circuit 28 which is also attached to substrate 14. Integrated circuit 28 contains electronic circuitry for electrically exciting the magneto-resistor elements so that the magneto-resistor resistance changes which occur can be employed in generating a digital output signal representative of the movement of ferromagnetic object 12. Electrical leads 30, 32, and 34 extending from the integrated circuit 28 provide external connections for the sensor device 10 with electrical ground, an output signal terminal and a source of electrical power, respectively. Although Figure 2 illustrates the sensor device 10 in a hybrid circuit form, the electronic processing circuitry could alternatively be formed directly on substrate 14 using fabrication techniques compatible with the processes and materials used in forming magneto-resistor elements MR1 and MR2 on substrate 14.

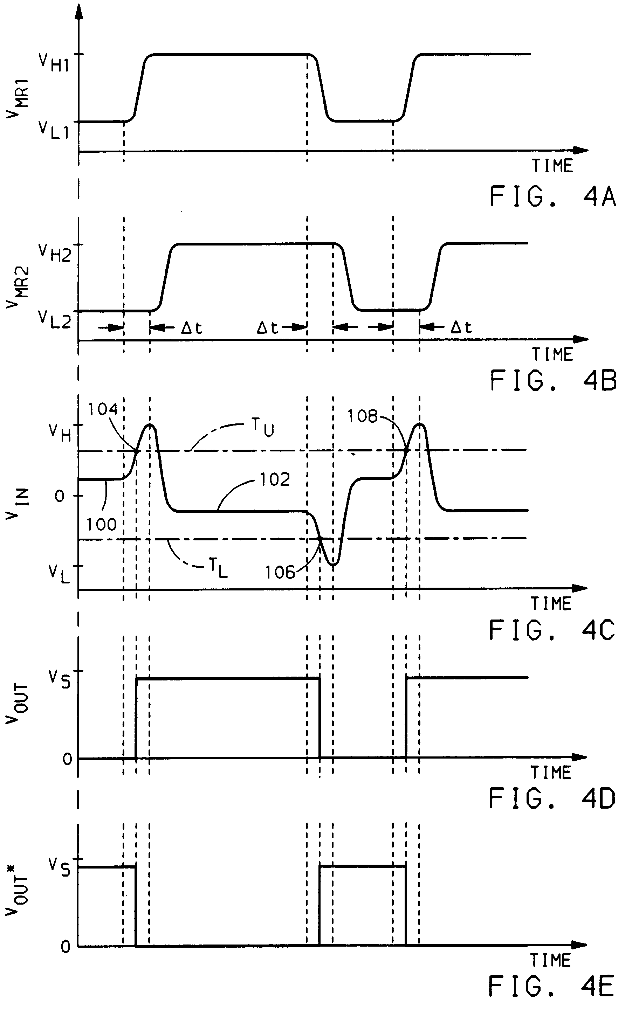

Referring to Figure 3, in the shown embodiment of electrical circuit contained within the integrated circuit 28 magneto-resistor element, MR1 is connected in series to resistor 38 at junction 24 and magneto-resistor element MR2 is connected in series to resistor 40 at junction 26. Each of these series connected resistor combinations are connected in parallel across junctions 42 and 22.

A source of voltage potential $+V_S$ is applied between junctions 34 and 30 (labelled as $+V_S$ and GND respectively) for electrically powering the sensing device 10. This same voltage potential $V_S$ can be directly applied to junction 42 or, as shown in Figure 3, an optional voltage regulating circuit 36 can be used to provide a different voltage potential $+V_B$ at junction 42 with respect to ground at junction 44, which is also connected to GND at junction 30.

The voltage potential $+V_B$ provides the means for electrically exciting or inducing currents to flow through the magneto-resistor elements to produce voltage drops designated as $V_{MR1}$ and $V_{MR2}$ across the elements MR1 and MR2, respectively. As an alternative to the voltage regulating circuit 36, each magneto-resistor could be excited by a separate source of constant or regulated current to induce a voltage drop across each magneto-resistor element.

Since each magneto-resistor element and its associated series resistor forms a voltage divider between circuit ground and the biasing voltage $+V_B$, the voltages drops across the magneto-resistive elements are given by:

$$V_{MR1} = V_{B*} R_{MR1}/(R_{38} + R_{MR1}) , \text{ and} \quad (1)$$

$$V_{MR2} = V_{B*} R_{MR2}/(R_{40} + R_{MR2}) , \quad (2)$$

where $R_{MR1}$ and $R_{MR2}$ represent the respective resistances of the magneto-resistive elements MR1 and MR2, and the resistances $R_{38}$ and $R_{40}$ are those of the respective resistors 38 and 40. A voltage drop $V_D$ from junction 24 to junction 26 is also shown in Figure 3. This voltage drop $V_D$ is equivalent to the difference between the voltage drops $V_{MR1}$ and $V_{MR2}$ across magneto-resistors MR1 and MR2, that is $V_D = (V_{MR1} - V_{MR2})$, which hereinafter will be referred to as the differential voltage signal $V_D$.

Since the magneto-resistive elements are substantially equal in value and in close physical proximity to each other, any change in the differential voltage $V_D$ due to temperature drift in the resistance of elements MR1 will be essentially negated or offset by the corresponding temperature drift in the resistance of element MR2. This also applies for temperature drift in resistance values of resistors 38 and 40, assuming they have substantially the same resistances, are in close physical proximity and are fabricated from the same materials. Consequently, the magnitude of the differential voltage signal $V_D$ is inherently compensated for temperature drifts in the resistance values of the magneto-resistor elements and resistors 38 and 40.

Junctions 24 and 26 are coupled via respective resistors 46 and 48 to the positive (+) and negative (-) input terminals of a comparator 50. Resistors 46 and 48 typically have the same resistance values, which are of sufficient magnitude to prevent any significant loading of the differential voltage across the magneto-resistor elements. As a result, the input voltage $V_{IN}$ which appears at the positive and negative input terminals of comparator 50 is substantially equal to the differential voltage signal $V_D$ appearing across junctions 24 and 26.

Power supply leads 56 and 58 of comparator 50 are connected to junctions 44 and 60 respectively, thereby coupling the comparator 50 across the power supply voltage $+V_S$ and GND in what is commonly known as a single power supply configuration. Any of a number of commercially available integrated circuits may be used to implement comparator 50 in such a fashion, for example, a Model LM193 comparator available from National Semiconductor Corporation. This configuration provides the advantage that only a positive supply voltage is required to power the comparator; however, comparator circuits which require positive and negative dual supply voltages could also be used.

Feedback resistor 52 is connected between the positive input of comparator 50 and its output terminal 54 to form a type of comparator known as a hysteresis comparator. With this type of comparator, the resistance value of resistor 52 with respect to that of resistor 46 establishes upper and lower threshold voltage values $T_U$ and $T_L$, respectively, for the voltage difference $V_D$ coupled across the positive and negative inputs of comparator 50. When the voltage $V_D$ exceeds the upper threshold voltage value $T_U$, comparator 50 operates to switch its output voltage $V_{OUT}$ to a high state (basically the power supply voltage $V_S$ reduced by a slight amount due to internal comparator losses). Likewise, when the differential voltage $V_D$ drops below the value of the lower threshold voltage value $T_L$, the comparator output voltage $V_{OUT}$ switches to a low state (approximately ground potential GND). As a result of this thresholding and hysteresis operation, comparator 50 generates a digital output signal $V_{OUT}$ which switches between high and low states based upon the magnitude of the differential voltage $V_D$ coupled to the comparator inputs.

Referring now to Figure 4, the operation of sensing device 10 will be described in terms of waveforms representing the time variation of voltages across selected junctions within the circuit of Figure 3, as the magnetic discontinuities in the surface of the ferromagnetic object move past the sensing device as shown in Figure 1.

Figure 4A illustrates a voltage waveform representative of the voltage drop $V_{MR1}$ that appears across magneto-resistor MR1 as the teeth 18 and slots 20 of ferromagnetic object 12 move in the direction indicated in Figure 1. As described above, the resistance of element MR1 is modulated between minimum and maximum values respectively as slots 20 and teeth 18 on ferromagnetic object 12 pass under element MR1. As a consequence, the voltage drop $V_{MR1}$ across element MR1 varies between a minimum and a maximum voltage $V_{L1}$ and $V_{H1}$, respectively, with the passage of the slots and teeth on ferromagnetic object 12.

Similarly, Figure 4B illustrates a voltage waveform representative of the voltage drop $V_{MR2}$ that appears across magneto-resistor MR2 that varies between a lower voltage $V_{L2}$ and an upper voltage $V_{H2}$ as respective slots 20 and teeth 18 of ferromagnetic object 12 pass under element MR2. Due to the spacing W separating element MR1 and MR2 on substrate 14, the transitions between the higher and lower voltages in the $V_{MR1}$ waveform occur prior in time to the corresponding transitions occurring in the $V_{MR2}$ waveform. This lead-lag relationship is illustrated in Figure 4B by the indicated time difference designated as $\Delta t$.

Figure 4C illustrates a voltage waveform for the differential input voltage $V_{IN}$ across the positive and negative input terminals of comparator 50. For all practical purposes, this differential input voltage $V_{IN}$ is equivalent to the differential voltage $V_D$ developed across the magneto-resistor elements, that is, $V_D = V_{MR1}-V_{MR2}$. Consequently, the waveform for the differential voltage $V_{IN}$ will generally vary as depicted in Figure 4C. This waveform has a maximum value represented by $V_H$, which is equal to the quantity $(V_{H1}-V_{L2})$, and has a minimum value represented by $V_L$, which is equal to the quantity $(V_{L1}-V_{H2})$. The portion of the voltage waveform $V_{IN}$ denoted by the numeral 100 generally has an amplitude equal to $(V_{L1}-V_{L2})$, while the portion of the waveform denoted by the numeral 102 has an amplitude equal to the value of $(V_{H1}-V_{H2})$.

While the two portions of the $V_{IN}$ waveform denoted by 100 and 102 may in general have different values, as shown in Figure 4C, these two portions will normally be at substantially the same voltage level. This is because the magneto-resistors MR1 and MR2 are fabricated on substrate 14 at the same time, using the same process and materials and, preferably, are formed to have substantially identical physical dimensions. As a result, the magneto-resistive elements MR1 and MR2 will have substantially the same resistance values, which will vary by substantially the same amounts as ferromagnetic object 12 moves past the magneto-resistor elements.

In addition to being at the same voltage level, it is also preferable that the two portions 100 and 102 of the $V_{IN}$ waveform be at the zero differential voltage level. In practice, this is accomplished by trimming the resistance of either of resistors 38 or 40 to achieve a zero differential input voltage $V_{IN}$ to the comparator 50, when the sensing device 10 is removed from the proximity of ferromagnetic object 12 or when both magneto-resistor elements are exposed to the same tooth or the same slot so that the intensity of the magnetic field passing through them is substantially the same.

Under the above conditions, the voltage waveforms $V_{MR1}$ and $V_{MR2}$ will be substantially the same, except for the indicated time delay $\Delta t$. As a result, the voltage waveform $V_{IN}$ will be centered about the zero volt level with $V_L = -V_H$. This ensures that the minimum to maximum voltage swing of the $V_{IN}$ waveform will be centered with respect to the upper and lower threshold voltage values established for comparator 50.

As is well known, the upper and lower threshold voltage values for comparator 50 can be adjusted by varying the resistance value of the feedback resistor 52 relative to that of resistor 46. The lines labelled $T_U$ and $T_L$ in Figure 4C represent respectively, the upper and lower threshold voltage levels at which comparator 50 is adjusted to switch its output signal $V_{OUT}$ between high and low states. The input signal $V_{IN}$ exceeds the upper threshold voltage at points 104 and 108 indicated on the waveform and $V_{IN}$ drops below the lower threshold voltage at point 106.

As shown by the waveform $V_{OUT}$ in Figure 4D, the comparator 50 switches its output signal $V_{OUT}$ from a low to high state when the input signal $V_{IN}$ exceeds the upper threshold voltage, and from the high to low state when $V_{IN}$ falls below the lower threshold voltage. Thus, comparator 50 generates a digital output signal $V_{OUT}$ indicative of the movement of the ferromagnetic object 12 past the sensing element 10.

As stated above, one of the primary advantages of operating the magneto-resistor elements in the above-described differential mode is the inherent temperature compensating affect. Temperature variations in the resistance of the magneto-resistive elements MR1 and MR2 produce substantially the same changes in their respective voltage drops $V_{MR1}$ and $V_{MR2}$, and since the comparator input $V_{IN}$ (or equivalently, $V_D$) is based upon the difference between these voltage drops $V_{MR1}$ and $V_{MR2}$, $V_{IN}$ remains substantially unchanged by the temperature variations in the resistances of the magneto-resistor elements. As a result, the magneto-resistive sensing device is quite insensitive to changes in operating temperature.

In order for the sensing device 10 to function as described above, the effective spacing W separating the magneto-resistive elements MR1 and MR2 (see FIGURES 1 and 2) is less than the smallest width separating adjoining discontinuities on the ferromagnetic object. For the ferromagnetic object 12 shown in Figure 1, the smallest width separating adjoining magnetic discontinuities is the slot width $W_S$. As the spacing W between elements MR1 and MR2 is increased, the delay $\Delta t$ between the leading response of element MR1 and the corresponding lagging response of element MR2 increases in a proportional manner. When pacing W is increased to exceed $W_S$, the delay $\Delta t$ will become sufficiently large and a positive (or negative) going edge of a pulse in the $V_{MR2}$ waveform will no longer immediately follow the positive (or negative) going edge of a pulse in the $V_{MR1}$ waveform associated with the same tooth (or slot). When this occurs, the differential voltage across the magneto-resistor elements, in this case the waveform $V_{IN}$ in Figure 4C, will no longer have a positive going pulse as the leading edge of a tooth first passes under MR1, followed by a negative going pulse as the trailing edge of the same tooth moves under element MR1. As a result, the high and low states of the digital output signal generated by the comparator will no longer coincide with the passage of teeth and slots under the magneto-resistor elements.

In order for the differential voltage represented by the waveform $V_{IN}$ of Figure 4C to achieve the largest possible maximum and minimum values ($V_H$ and $V_L$, respectively), the spacing W between the magneto-resistive elements is at least large enough so that the leading magneto-resistor (MR1 in this case) undergoes a complete transition between its high and low resistance values prior to the start of the corresponding transition in the resistance values for the trailing magneto-resistor.

The minimum spacing W that still enables $V_{IN}$ to achieve its largest voltage swing will generally have to be determined empirically, since its value will depend upon the the dimensions of several different physical features such as the the the air gap G, the width of teeth and slots $W_T$ and $W_S$, and the slot depth $_D$. Of course the sensing device will still function if the magneto-resistor elements are separated by less than the minimum spacing, but the peak-to-peak voltage swing of $V_{IN}$ will not be as large as possible, which unnecessarily reduces the sensitivity of the sensing device.

In this embodiment, digital output signal is representative of the relative spacing between the teeth and slots passing by the sensing device. A comparison of the waveforms of FIGURES 4A and 4D shows that the comparator output $V_{OUT}$ assumes its high state during the time when a tooth is passing under element MR1 and assumes its low state during the passage of a slot. Thus, the width of the pulses and the spacing between pulses in the $V_{OUT}$ waveform correspond to the relative widths of teeth and slots passing under the sensing device 10. As a consequence of this relationship, the sensor can provide information related to absolute position of a ferromagnetic object 12 having teeth and/or slots of differing widths. For example, a single very narrow tooth or slot could be provided on the ferromagnetic object to provide a recognisable or distinguishable position synchronization pulse in the $V_{OUT}$ signal.

By counting the number of pulses which occur in the sensor output signal $V_{OUT}$ during a predetermined time, the speed at which a ferromagnetic object 12 is moving can be determined, provided there is some uniformity in the spacing of the discontinuities on the ferromagnetic object.

Similarly, it is possible in some embodiments to provide information as to the direction of movement of a ferromagnetic object. As described above, the output waveform $V_{OUT}$ illustrated in Figure 4D is produced during movement of the ferromagnetic object 12 in the direction indicated in Figure 1. If the direction of motion of the ferromagnetic object 12 is reversed (right to left instead of left to right in the view of Figure 1), the response of element MR2 to the movement will then lead that of element MR1. This reversal in the roles of the magneto-resistors results in an inversion of the comparator input signal $V_{IN}$, which in turn acts to invert the comparator output signal as indicated by the waveform labelled $V_{OUT}^*$ in Figure 4E. It will be noted that the duty cycle of the comparator output signal is significantly larger when the ferromagnetic object 12 moves to the right (Figure 4D) as compared with movement to the left (Figure 4E), thus providing means for determining the direction of motion of the ferromagnetic object. It will be recognized that this behavior is a result of the width of teeth and width of slots on ferromagnetic object 12 not being the same.

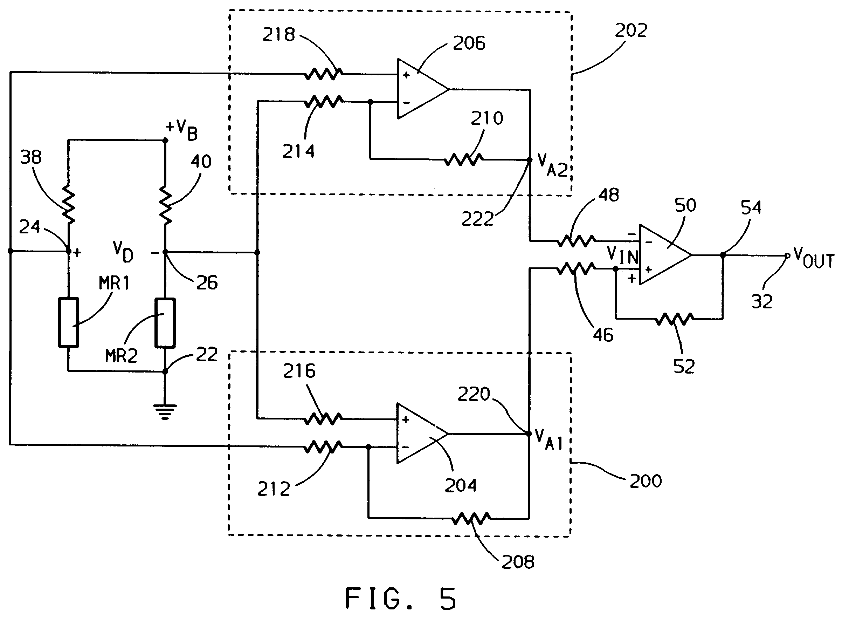

Referring to Figure 5, another embodiment of circuit includes a pair of amplifier circuits 200 and 202 inserted between the magneto-resistive elements and the hysteresis comparator circuit. Power supply connections to the amplifiers and comparator circuits have been excluded to simplify the description.

Amplifier circuits 200 and 202 contain standard integrated circuit operational amplifiers 204 and 206, such as Model LM158 commercially available from the National Semiconductor Corporation. Both operational amplifiers 204 and 206 are configured in an inverting mode, where their inverting gains are determined by the ratio of their respective feedback resistors 208 and 210 to their respective negative input resistors 212 and 214. To maintain balanced inputs for the operational amplifiers, their positive input resistors 216 and 218 are typically selected to have the same resistance values as their respective negative input resistors 212 and 214 and also to have sufficient resistance to avoid any significant loading across the magneto-resistive elements MR1 and MR2. In addition, it is desirable that resistors 208, 212, and 216 have the same resistance values as resistors 210, 214 and 218, respectively, so that each inverting amplifier has the same inverting gain -A.

As will be apparent, amplifier circuit 200 acts to amplify the differential voltage $V_D$, while amplifier circuit 206 acts to amplify and invert the differential voltage $V_D$ (that is, to shift its phase by 180 degrees), due to the reversal in polarity of $V_D$ appearing across the input terminals of operational amplifiers 204 and 206.

For the purpose of the following description, it has been assumed that the magneto-resistive elements have been fabricated to have the same resistive values and resistor 38 or 40 has been trimmed as described above to produce a differential signal $V_D$ with positive and negative peaks of $V_P$

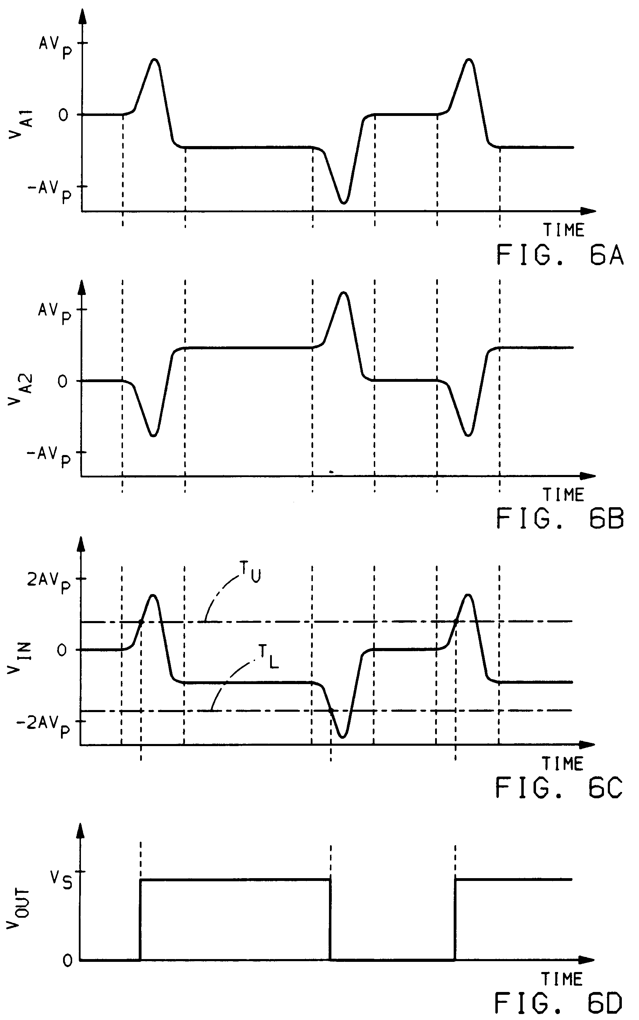

and $-V_P$ respectively, centered about the zero volt level. Accordingly, amplifier circuit 200 produces an intermediate signal $V_{A1}$ at junction 220, which has the waveform shown in Figure 6A, while amplifier circuit 202 produces an intermediate signal $V_{A2}$ at junction 222, which has the waveform shown in Figure 6B. The the waveform for the intermediate signal $V_{A1}$ is proportional to and represents an amplified version of the differential voltage $V_D$, while the waveform for the intermediate signal $V_{A2}$ is proportional to and represents an amplified and inverted (phase shifted 180 degrees) version of the differential voltage $V_D$.

The waveform for the voltage $V_{IN}$ appearing at the input terminals of comparator 50 is shown in Figure 6C, along with the upper and lower voltage threshold voltages $T_U$ and $T_L$. Figure 6D illustrates the corresponding waveform for the digital output signal $V_{OUT}$ generated by comparator 50 in response to the $V_{IN}$ input signal waveform shown in Figure 6C. Note that due to the action of the amplifying circuits 200 and 202, the peak-to-peak voltage swing of the $V_{IN}$ waveform is twice as large as could be achieved by merely amplifying the differential voltage signal with a single amplifier having a gain of A (that is $4AV_P$ as compared to $2AV_P$). This is due to the push-pull effect achieved by combining the amplified differential voltage signal $AV_D$ with its amplified and inverted counterpart $-AV_D$ at the input terminals of the comparator 50.

Since the peak-to-peak swing of the comparator input signal $V_{IN}$ is substantially increased in the circuit of Figure 5, as compared to the circuit of Figure 3, the embodiment in Figure 5 provides the sensing device 10 with a significant increase in sensitivity. It has been found that this increase in sensitivity permits the sensing device to be used in applications requiring larger spacings between the sensor 10 and the ferromagnetic object 12 (increased air gap G in Figure 1). Also, since the upper and lower threshold voltage levels $T_U$ and $T_L$ can be increased, the sensing device is less prone to generating erroneous pulses in its digital output signal due to the pick-up of extraneous electrical noise.

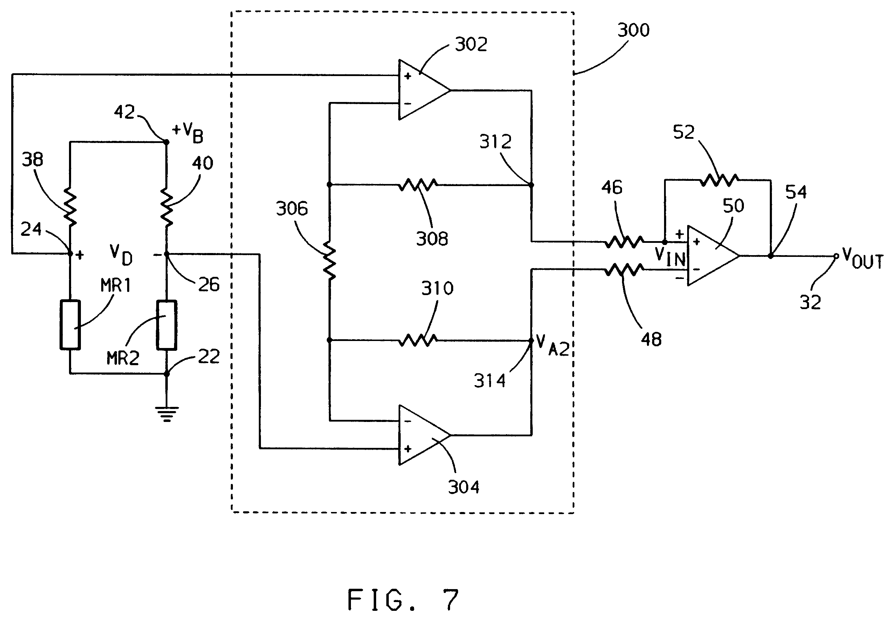

Referring now to Figure 7, there is shown another embodiment of circuit requiring fewer components. The amplifier configuration 300 has been used in the past as a differential voltage preamplifier stage in instrumentation amplifiers (see for example, page 3-452 in the 1989 National Semiconductor General Purpose Linear Device Data Book). The circuit requires two operational amplifiers 302 and 304, just as in the circuit of Figure 5, but only three resistors 306, 308, and 310, compared to six resistors required in the circuit of Figure 5.

The amplifier circuit 300 performs the same functions as the individual amplifier circuits 200 and 202 described in the previous embodiment, in that intermediate voltages $V_{A1}$ and $V_{A2}$ are produced at junctions 312 and 314, respectively, in response to the application of the differential input signal $V_D$ across the positive inputs of the operational amplifiers 302 and 304. The waveforms corresponding to these intermediate voltages are the same as those of FIGURES 6A and 6B, with the exception that the gain for the differential voltage preamplifier configuration 300 is given by:

$$A = (1 + R_F/R_G), \qquad (3)$$

where $R_F$ represents the resistance value of each of the resistors 308 and 310, and $R_G$ represents the resistance value of resistor 306. The other voltage waveforms presented in Figure 6 are equally applicable to the operation of the embodiment of Figure 7.

In the embodiments described above, a hysteresis-type comparator circuit was utilized to generate a digital output signal in response to the differential voltage signal appearing across the magneto-resistive elements. It will be recognized by those skilled in the art that several other electronic devices are equally well suited to performing this function. For example, a Schmitt trigger, a bistable multivibrator, or a D-type flip-flop can easily be configured to trigger at some point on the edge of the positive going pulse in the differential voltage signal and reset at some point on the negative going pulse.

The disclosures in United States patent application no. 914, 629, from which this application claims priority, and in the abstract accompanying this application are incorporated herein by reference.

## Claims

1. A device for sensing movement of a ferromagnetic object having a surface including successive magnetic discontinuities along a direction of movement of the object, adjoining discontinuities being spaced by predetermined amounts; the device comprising first and second magneto-resistive elements (MR1, MR2) having respective first and second resistance values; field generating means (16) for generating a magnetic field to bias the magneto-resistive elements such that their respective resistance values are modulated on movement of the discontinuities of the ferromagnetic object relative to the magneto-resistive elements; excitation means (36-40) for electrically exciting the magneto-resistive elements to produce a first voltage drop (VMR1) across the first magneto-resistive element (MR1) and a second voltage drop (VMR2) across the second magneto-resistive element (MR2) on the basis of their respective resistance values; and an electrical circuit (46-52) for generating a digital output signal related to the difference between the first and second voltage drops and indicative of movement of the ferromagnetic object relative to the magneto-resistive elements.

2. A device according to claim 1, wherein the excitation means (36-40) is adapted to develop a differential voltage signal (VD) corresponding to the difference between the first and second voltage drops across the magneto-resistive elements; the device comprising first generating means (202) for producing a first intermediate signal having an amplitude proportional to the differential voltage signal; second generating means (200) for producing a second intermediate signal having an amplitude proportional to an inversion of the differential voltage signal; the electrical circuit (46-52) being adapted to produce a digital output signal in response to the first and second intermediate signals.

3. A device according to claim 2, wherein the first generating means includes a non-inverting amplifier (206), the second generating means includes an inverting amplifier (204) and the electrical circuit includes a hysteresis comparator circuit.

4. A device according to claim 2 or 3, wherein the excitation means includes amplifying means for amplifying the differential voltage, the electrical circuit being responsive to the amplified differential voltage.

5. A device according to claim 4, wherein the amplifying means comprises a differential voltage preamplier.

6. A device according to any preceding claim, wherein the electrical circuit is adapted to produce a digitial output signal having a high level when the difference between first and second voltage drops or between the first and second intermediate signals exceeds a first predetermined threshold value (Tu) and a low level when the difference between the first and second voltage drops or between the first and second intermediate signals is less than a second predetermined threshold value (T1).

7. A method of sensing movement of a ferromagnetic object having a surfacing including successive magnetic discontinuities along a direction of movement of the object, adjoining discontinuities being spaced by predetermined amounts; the method comprising the steps of providing first and second magneto-resistive elements (MR1, MR2) having respective first and second resistance values; positioning the magneto-resistive elements substantially the same distance from the surface of the ferromagnetic object and spacing the magneto-resistive elements apart from each other by a distance less than a smallest width selected from among the widths spacing adjoining discontinuites of the ferromagnetic object; generating a magnetic field to bias the magneto-resistive elements such that their respective resistance values are modulated on movement of the magneto-resistive elements; electrically exciting the magneto-resistive elements to produce a first voltage drop (VMR1) across the first magneto-resistive element (MR1) and a second voltage drop (VMR2) across the second magneto-resistive element (MR2) on the basis of their respective resistance values; and generating a digital output signal related to the difference between the first and second voltage drops and indicative of movement of the ferromagnetic object relative to the magneto-resistive elements.

8. A method according to claim 7, wherein the ferromagnetic object has a surface containing interposed slots and teeth, the method sensing movement of the slots and teeth.

FIG. 1

FIG. 2

FIG. 3

FIG. 4A

FIG. 4B

FIG. 4C

FIG. 4D

FIG. 4E

FIG. 5

FIG. 6A

FIG. 6B

FIG. 6C

FIG. 6D

FIG. 7

$V_{OUT}$ 32 54 50 52 46 48 $V_{IN}$ 300 $V_{A2}$ 312 314 302 304 308 310 306 $+V_B$ 40 26 22 42 $V_D$ MR1 MR2 38 24

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | US-A-4 629 982 (W.G. KIESLICH)<br>* column 3, line 23 - column 5, line 18 *<br>* column 7, line 48 - column 8, line 7;<br>figures 1-4,5A,5B * | 1,7,8 | G01D5/16 |
| A | | 2-6 | |
| | --- | | |
| Y | EP-A-0 331 828 (KABUSHIKI KAISHA YASKAWA DENKI SEISAKUSHO)<br>* column 7, line 42 - column 8, line 13;<br>figures 3,4 * | 1,7,8 | |
| A | | 2-6 | |
| | --- | | |
| A | US-A-4 490 674 (S. ITO)<br>* column 3, line 37 - column 4, line 6;<br>figures 5A,5B * | 1-8 | |
| | ----- | | |
| | | | TECHNICAL FIELDS SEARCHED (Int. Cl.5 ) |
| | | | G01D<br>H03K |

The present search report has been drawn up for all claims

| Place of search | Date of completion of the search | Examiner |
|---|---|---|
| THE HAGUE | 28 OCTOBER 1993 | CHAPPLE I.D. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...................................................................

& : member of the same patent family, corresponding
    document

EPO FORM 1503 03.82 (P0401)